(19) Europäisches Patentamt

**European Patent Office**

**Office européen des brevets**

(11) Numéro de publication: **0 271 406 B1**

(12) **FASCICULE DE BREVET EUROPEEN**

(45) Date de publication de fascicule du brevet: **06.05.92** (51) Int. Cl.5: **G11C 7/00**

(21) Numéro de dépôt: **87402760.0**

(22) Date de dépôt: **04.12.87**

(54) **Dispositif d'autosynchronisation des circuits de sortie d'une mémoire.**

(30) Priorité: **05.12.86 FR 8617041**

(43) Date de publication de la demande:
**15.06.88 Bulletin 88/24**

(45) Mention de la délivrance du brevet:
**06.05.92 Bulletin 92/19**

(84) Etats contractants désignés:
**DE ES FR GB IT**

(56) Documents cités:
**EP-A- 0 144 223**
**EP-A- 0 180 001**

**IEEE JOURNAL OF SOLID-STATE CIRCUITS,
vol. SC-20, no. 5, octobre 1985, pages
941-950, IEEE, New York, US; L.C. SOOD et
al.: "A fast 8Kx8 CMOS SRAM with internal
power down design techniques"**

(73) Titulaire: **SGS-THOMSON MICROELECTRO-
NICS S.A.**
**101 Boulevard Murat**
**F-75016 Paris(FR)**

(72) Inventeur: **Ferrant, Richard**
**THOMSON-CSF SCPI 19, avenue de Messine**
**F-75008 Paris(FR)**

(74) Mandataire: **Schmit, Christian Norbert Marie
et al**
**Cabinet Ballot-Schmit 7, rue Le Sueur**
**F-75116 Paris(FR)**

Rank Xerox (UK) Business Services
(−/2.18/2.0)

**EP 0 271 406 B1**

## Description

La présente invention concerne un dispositif d'autosynchronisation des circuits de sortie d'une mémoire. Elle concerne plus particulièrement un dispositif d'autosynchronisation des circuits de sortie d'une mémoire comme indiqué dans le préambule de la revendication 1 et comme connu par example du EP-A-0 144 223.

La plupart des mémoires actuelles,c'est à dire aussi bien les mémoires ROM (read only memory) que les mémoires RAM (random access memory), utilisent des circuits de sortie comportant un état haute impédance, c'est è dire pouvant prendre un niveau indéterminé correspondant à une sortie déconnectée du circuit. Cet état haute impédance permet de connecter en parallèle les sorties de plusieurs circuits dont un seul est mis en service à la fois. En général, le contrôle de cet état haute impédance se fait en utilisant un circuit en logique combinatoire dont les caractéristiques de propagation ne sont pas liées aux caractéristiques de la logique de sortie. Ce circuit en logique combinatoire est en général constitué de portes logiques commandées par des signaux tels que les signaux $\overline{E},\overline{W},\overline{OE}$ de commande du circuit de sortie. Il résulte de l'utilisation de ce type de circuit que le passage de haute impédance en basse impédance se produit très tôt dans le cycle de lecture et d'écriture. Cela entraine un certain nombre de commutations parasites des étages de sortie; car les amplificateurs de lecture sont à ce moment incapables de donner une information utile.

Ces commutations parasites présentent les inconvénients suivants:

- un encombrement inutile du bus de sortie qui peut pénaliser le système dans lequel est intégrée la mémoire,
- des appels de courant internes au circuit résultant des commutations des étages de sortie constitués par des transistors de puissance présentant une largeur de plusieurs centaines de microns. Ces appels de courant génèrent un bruit particulièrement gênant, car le circuit se trouve alors dans une phase d'amplification de petits signaux. En conséquence, la dégradation des performances du système peut être importante.

La présente invention a pour but de remédier à ces inconvénients en proposant un nouveau circuit de contrôle de l'état haute impédance utilisable dans les circuits de sortie des mémoires travaillant en mode horloge interne.

Ainsi la présente invention a pour objet un dispositif d'autosynchronisation pour les circuits de sortie des mémoires travaillant en mode horloge interne, ces circuits de sortie comportant une porte "3 états" (P) placée en série entre un amplificateur de lecture (A) et une porte de sortie (S), caractérisé en ce qu'il est constitué par un circuit en logique séquentielle (10 à 20) ne permettant le passage de la porte "3 états" (P) en basse impédance qu'au moment où une information est disponible en sortie de l'amplificateur de lecture (A), l'amplificateur de lecture (A) étant commandé par le même signal horloge pulsé (∅1) que le circuit en logique séquentielle, le signal horloge pulsé (∅1) étant constitué par des impulsions dont la durée est au moins égale au temps de réponse de l'amplificateur de lecture (A), le circuit en logique séquentielle (10 à 20) ayant un temps de réponse egal au temps de réponse de l'amplificateur de lecture (A).

Selon un mode de réalisation préférentiel, le circuit en logique séquentielle est constitué par une bascule D à verrouillage commandée par un signal-horloge pulsé dont les sorties commandent la porte " 3 états " et par une boucle de mémorisation.

D'autre part, la remise à zéro de la bascule D est réalisée à l'aide d'une logique combinatoire commandée par les signaux $\overline{E}$ et $\overline{W}$. Au moins pendant le mode lecture, la sortie D de la bascule D est positionnée au niveau logique 1. A titre d'exemple, la sortie D peut être alimentée par la tension d'alimentation Vcc. Lorsque la mémoire comporte le signal de commande $\overline{OE}$, les signaux de sortie de la bascule D sont combinés avec le signal $\overline{OE}$ avant d'être envoyés sur la porte " 3 états".

Selon une autre caractéristique de la présente invention, lorsque la mémoire comporte le signal de commande $\overline{OE}$, la boucle de mémorisation est réalisée en utilisant un des circuits inverseurs de la porte " 3 états ".

Les caractéristiques et avantages de la présente invention apparaîtront à la lecture de la description de divers modes de réalisation, faite ci-après avec référence aux dessins ci-annexés dans lesquels:
- la figure 1 représente un circuit de sortie d'une mémoire selon l'art antérieur,
- la figure 2 représente un circuit de sortie d'une mémoire muni d'un dispositif d'autosynchronisation conforme à la présente invention,
- la figure 3 représente un autre mode de réalisation d'un circuit de sortie d'une mémoire muni d'un dispositif d'autosynchronisation conforme à la présente invention,
- la figure 4 est un diagramme des temps d'un cycle d'écriture montrant les avantages de la présente invention.

2

Pour simplifier la description, sur les figures les mêmes éléments portent les mêmes références.

La présente invention sera décrite sans se référer à un type particulier de mémoire. En effet elle s'applique aussi bien à des mémoires ROM qu'à des mémoires RAM. La mémoire utilisée doit être seulement du type à horloge interne comme cela sera expliqué ci-après.

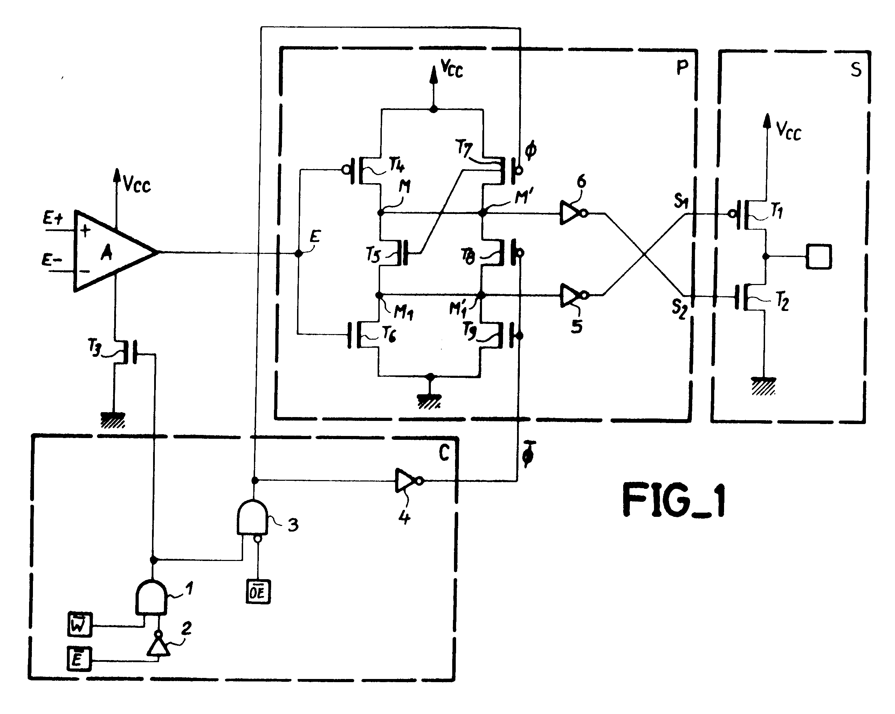

Sur la figure 1, on a représenté un circuit de sortie d'une mémoire selon l'art antérieur. Ce circuit comporte essentiellement un amplificateur de lecture A, une porte " 3 états" P, un étage de sortie S et un circuit C de contrôle du passage en haute impédance. L'amplificateur de lecture A est constitué par un amplificateur différentiel qui reçoit sur ses entrées les signaux E+ et E- provenant des lignes de bit correspondant à une ligne de cellules-mémoire. La sortie de l'amplificateur différentiel est commandée par un signal issu du circuit C. En fait le signal issu du circuit C est appliqué sur la grille d'un transistor MOS T3 à canal n dont l'une des electrodes, à savoir la source avec la technologie habituellement utilisé, est reliée à la masse et l'autre electrode ou drain à l'entrée de commande de l'amplificateur différentiel. La sortie de l'amplificateur différentiel est reliée à l'entrée de la porte " 3 états ".

Dans le mode de réalisation représenté, la porte " 3 états" est constituée par deux ensembles de transistors MOS montés en parallèle entre la tension d'alimentation et la masse. Le premier ensemble comprend un transistor MOS à canal p T4 monté en série avec un transistor MOS à canal n T5, lui-même monté en série avec un transistor MOS à canal n T6, la source du transistor T4 étant reliée à la tension d'alimentation Vcc et la source du transistor T6 à la masse. D'autre part, le drain du transistor T4 est relié au drain du transistor T5 dont la source est reliée au drain du transistor T6. Les grilles des transistors T4 et T6 sont reliées ensemble et connectées au noeud E représentant l'entrée de la porte " 3 états ". Le second ensemble comprend un transistor MOS à canal p T7 monté en série avec un transistor à canal p T8, lui-même monté en série avec un transistor à canal n T9, la source du transistor T7 étant reliée à la tension Vcc et la source du transistor T9 à la masse. D'autre part, le drain du transistor T7 est relié à la source du transistor T8 dont le drain est connecté au drain du transistor T9. Les grilled des transistors T8 et T9 sont connectées ensemble et recoivent le signal de commande ∅ tandis que la grille du transistor T7 reçoit le signal de commande $\overline{\emptyset}$. D'autre part, la grille du transistor T5 est reliée à la grille du transistor T7. Les noeuds M et M′ se trouvant respectivement entre les transistors T4 et T5 et les transistors T7 et T8 sont connectés ensemble et à l'entrée d'un inverseur 6 dont la sortie S2 est une des sortes de la porte " 3 états ". De même, les noeuds M1 et M1′ se trouvant respectivement entre les transistors T5 et T6 et les transistors T8 et T9 sont connectés ensemble et à l'entrée d'un inverseur 5 dont la sortie S1 est l'autre sortie de la porte " 3 états".

Les sorties S1 et S2 de la porte " 3 états " sont connectées respectivement aux entrées de l'étage de sortie S. Cet étage est constitué de deux transistors MOS de puissance montés en cascade. De manière plus spécifique, il comporte un transistor MOS à canal p T1 dont la source est connectée à la tension Vcc et le drain au drain d'un transistor MOS à canal n T2 dont la source est connectée à la masse. Les grilles des transistors T1 et T2 sont connectées aux sorties S1 et S2 de la porte " 3 états ". Le signal de sortie du circuit est obtenu sur la borne S3.

D'autre part, les signaux ∅ et $\overline{\emptyset}$ de contrôle de l'état haute impédance sont obtenus à partir du circuit C. Ce circuit est dans le mode de réalisation représenté, un circuit en logique combinatoire. Il est, ici, constitué essentiellement d'une porte ET 1 qui reçoit sur une de ses entrées le signal de commande d'écriture $\overline{W}$ et sur son autre entrée le signal de sortie d'un inverseur 2 recevant en entrée le signal de commande $\overline{E}$. Dans le cas des mémoires qui ne comportent pas de signal $\overline{W}$ telles que les mémoires ROM, ce signal peut être remplacé par un niveau logique 1. D'autre part, si la mémoire comporte le signal $\overline{OE}$, celui-ci est envoyé après inversion sur une entrée d'une porte ET 3 dont l'autre entrée reçoit la sortie de la porte ET 1. Si la mémoire ne comporte pas le signal $\overline{OE}$, la porte ET 3 est supprimée. La sortie de la porte ET 3 donne le signal de commande ∅ et après inversion dans l'inverseur 4, le signal de commande $\overline{\emptyset}$. D'autre part le signal de sortie de la porte ET 1 est envoyé sur la grille du transistor MOS T3 qui commande la sortie de l'amplificateur différentiel.

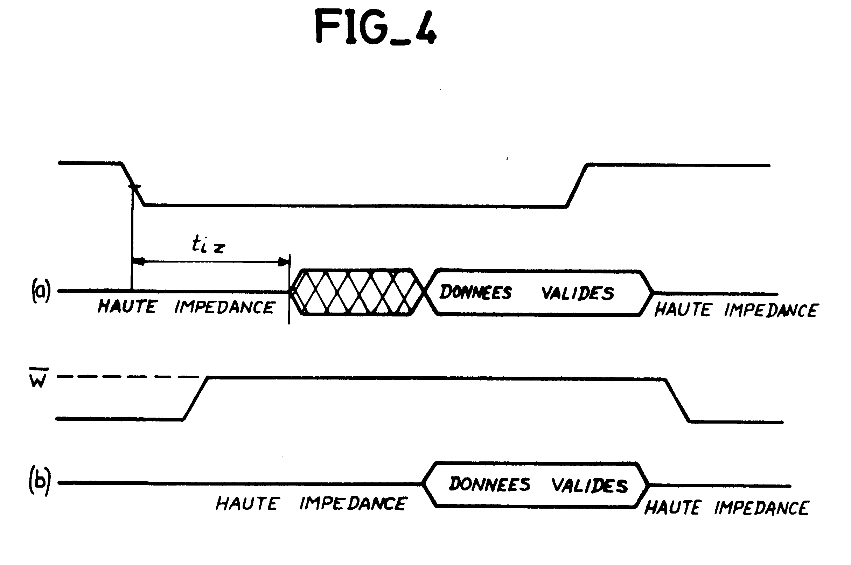

Le fonctionnement de la porte " 3 états " est tel que, lorsque le signal de commande ∅ est au niveau logique 1, la porte se trouve dans l'état basse impédance et les sorties S1 et S2 sont à des niveaux logiques fonctions du niveau logique présent sur E. Toutefois, lorsque le signal de commande ∅ est au niveau logique 0, la porte se trouve dans l'état haute impédance. En fait, la porte se trouve dans l'état basse impédance lorsque les signaux $\overline{E}$ et $\overline{OE}$ sont au niveau logique 0 et le signal $\overline{W}$ au niveau logique 1. Aussi, les caractéristiques de propagation du circuit C n'étant pas liées avec les caractéristiques de la logique de lecture, il en résulte que le passage de la haute impédance à la basse impédance se produit très tôt dans le cycle de lecture, comme représenté par le diagramme (a) de la figure 4, et cela entraine un certain nombre de commutations parasites des étages de sortie. Ces commutations sont symbolisées par la partie hachurée.

EP 0 271 406 B1

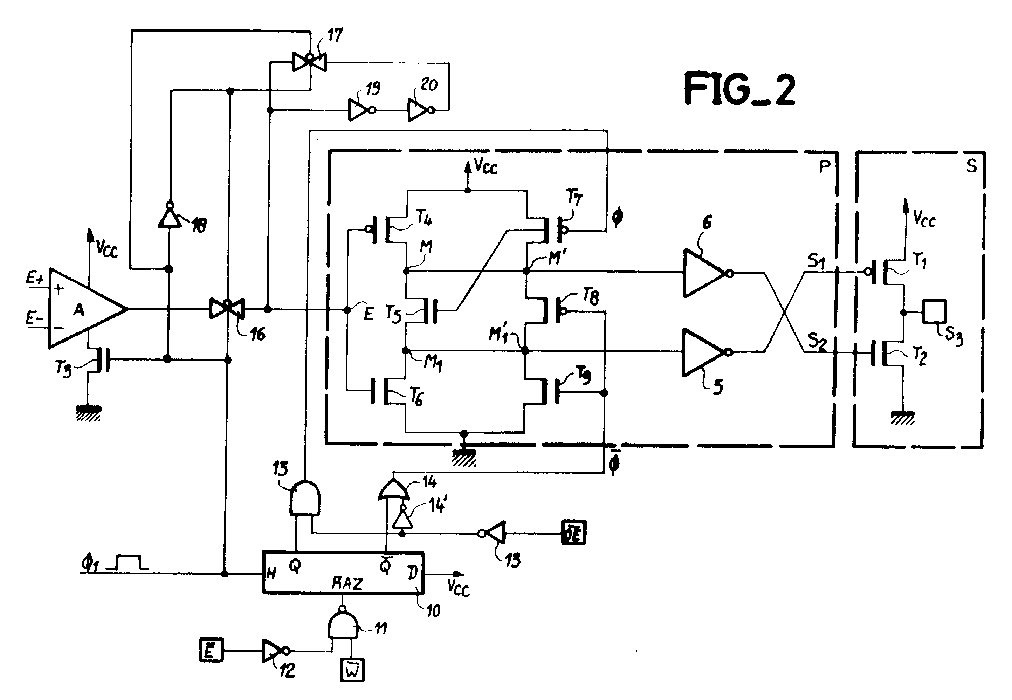

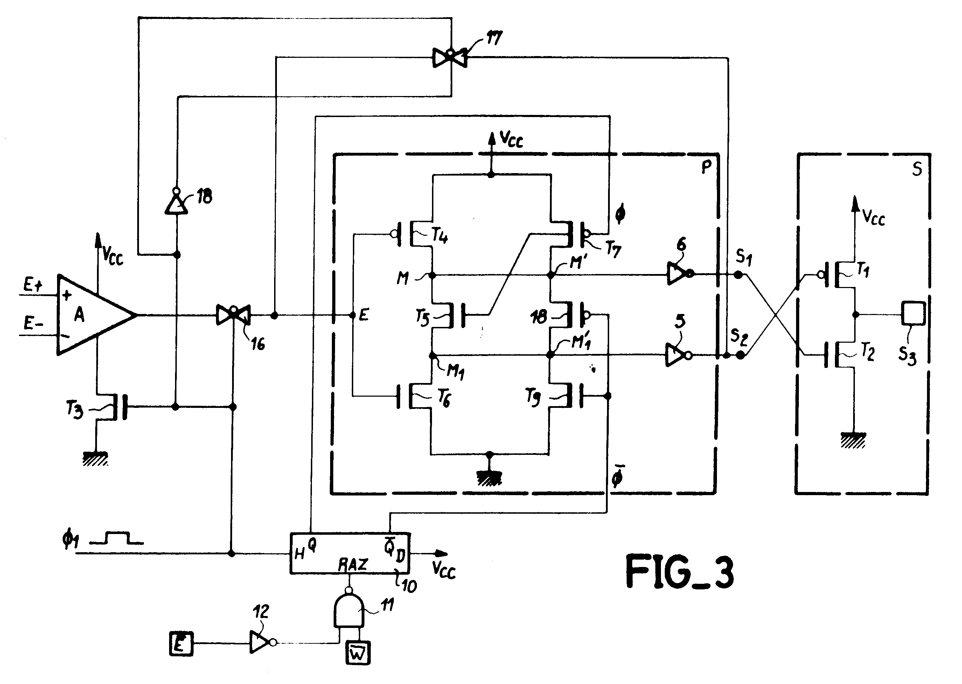

Pour remédier à cet inconvénient, on a modifié le circuit C en logique combinatoire en un circuit en logique séquentielle comme représenté sur les figures 2 et 3. Sur ces figures, les circuits A,P et S sont identiques à ceux représentés sur la figure 1. En conséquence, les ne seront pas redécrits.

Comme représenté sur les figures 2 et 3, le circuit en logique séquentielle est constitué par une bascule D à vérrouillage 10 comportant une commande horloge. L'entrée D de la bascule est positionnée au niveau logique 1, au moins pendant le mode lecture. Dans le mode de réalisation représenté, elle est reliée à la temsion Vcc. L'entrée H de la bascule reçoit le signal pulsé Ø1 qui est constitué par un des signaux horloges de la mémoire. Ce signal Ø1 est aussi appliqué sur la grille du transistor MOS T3 de commande de l'amplificateur différentiel A. D'autre part, l'entrée RAZ de la bascule reçoit un signal qui est une combinaison des signaux de commande $\overline{E}$ et $\overline{W}$. De manière spécifique, le signal de commande $\overline{E}$ est envoyé à travers un inverseur 12 sur une des entrées d'une porte NAND 11 dont l'autre entrée reçoit le signal de commande $\overline{W}$.Dans le mode de réalisation de la figure 2, les sorties Q et $\overline{Q}$ sont connectées respectivement à une des entrées d'une porte ET 15 et d'une porte OU 14. L'autre entrée de la porte ET 15 reçoit le signal de sortie d'un inverseur 13 dont l'entrée reçoit le signal de commande $\overline{OE}$, tandis que l'autre entrée de la porte OU 14 reçoit le signal issu d'un inverseur 14′ connecté en sortie de l'inverseur 13. La sortie de la porte ET 15 est connectée sur l'entrée Ø de la porte " 3 états " tandis que la sorte de la porte OU 14 est connectée sur l'entrée $\overline{Ø}$ de la porte " 3 états". Dans le cas de la figure 3, les sorties Q et $\overline{Q}$ sont directement connectées aux entrées respectives Ø et $\overline{Ø}$ de la porte " 3 états ".

Comme l'amplificateur de lecture est commandé par un signal pulsé, il est nécessaire de mémoriser l'information dans les étages suivants. Deux boucles de mémorisation ont été représentées respectivement sur les figures 2 et 3 en fonction de la présence ou de la non présence du signal de commande $\overline{OE}$.

La boucle de mémorisation de la figure 2 comporte une porte de transfert 16 dont l'entrée est reliée à la sortie de l'amplificateur de lecture A et dont la sortie est connectée à l'entrée de la porte " 3 états " et une porte de transfert 17 dont l'entrée est connectée à la sortie de la porte de transfert 16 à travers deux inverseurs 19 et 20 et la sortie est connectée à l'entrée de la porte " 3 états ". La porte de transfert 16 est commandée sur l'entrée de commande directe par Ø1 et sur l'entrée de commande inversée par $\overline{Ø1}$ obtenu en envoyant le signal Ø1 sur un inverseur 18. D'autre part, la porte de transfert 17 est commandée sur l'entrée de commande directe par $\overline{Ø1}$ et sur l'entrée de commande inversée par Ø1.

La boucle de mémorisation de la figure 3 est sensiblement identique à celle de la figure 2. La différence réside dans le fait que l'entrée de la porte de transfert 17 est directement connectée à la sortie S2 de la porte " 3 états ".

On expliquera le fonctionnement du circuit conforme à la présente invention en utilisant la table de vérité d'une bascule D à verrouillage avec entrée horloge donnée ci-après:

## D à vérrouillage avec entrée horloge

| RAZ | H | D | Q | $\overline{Q}$ | SORTIE |
|---|---|---|---|---|---|
| 1 | X | X | 0 | 1 | HI |
| 0 | ⌐⌐ | 0 | 0 | 1 | HI |
| 0 | ⌐⌐ | 1 | 1 | 0 | BI |
| 0 | ‾‾⌐‾ | X | Q | $\overline{Q}$ | pas modifié |

Dans le tableau ci-dessus, X signifie que le niveau logique est indifférent, HI et BI signifient respectivement haute impédance et basse impédance.

Ainsi , lorsque le RAZ est au niveau logique 1, c'est à dire si le mode lecture n'est pas activé, quel que soit le niveau logique de l'horloge et de l'entrée D, la sortie de la porte " 3 états " sera en haute impédance, car Q est au niveau logique 0. En mode lecture, la sortie de la porte " 3 états " passera en basse impédance sur le front montant du signal horloge, car l'entrée D se trouve au niveau logique 1. Le front descendant du signal horloge ne modifie pas l'état de la sortie de la porte " 3 états " qui reste en basse impédance. Cette sortie repasse en haute impédance lorsque le signal RAZ repasse au niveau logique 1, c'est à dire à la fin du cycle de lecture.

4

D'autre part, l'amplificateur de lecture n'est plus commandé par un signal statique comme dans l'art antérieur, mais par le signal horloge Ø1 qui n'apparait qu' à la fin de la phase d'initialisation du cycle de lecture. Le signal horloge Ø1 est un signal pulsé de durée au moins égale au temps de réponse de l'amplificateur de lecture:

En conséquence, si la basule D a un délai propre égal à celui de l'amplificateur, le passage de la haute à la basse impédance se produira à l'instant précis où l'amplificateur délivre une donneé valide. Cela permet d'éliminer toutes les transitions inutiles sur les étages de sorties et le bus.

D'autre part, la commande pulsée de l'amplificateur nécessite la mémorisation de l'information dans les étages suivants du circuit de sortie. Cela explique la présence des boucles de mémorisation représentées sur les figures 2 et 3.

Il est possible d'utiliser cette commande pulsée pour le contrôle du décodage. Dans ce cas, les décodeurs et les amplificateurs de lecture ne sont actifs qu'ensemble. Cela permet de réduire la consommation des amplificateurs au strict nécessaire à l'obtention d'une donnée.

Le dispositif conforme à la présent invention présente les avantages suivants:

- laisser les sorties du circuit de sortie en haute impédance pendant la presque totalité du premier cycle de lecture après écriture ou "standby",comme représenté sur la figure 4 diagramme (b) sur lequel on voit que la sortie est en haute impédance pendant 90% du cycle contre 20% avec les circuits de l'art antèrieur;
- conserver les données du cycle précedent dans les mêmes proportions lors des accés controlés par les adresses;
- supprimer la majeure partie des commutations internes des transistors de sortie, et donc permettre aux circuits de détection de fonctionner dans un environnement avec moins de bruit.

Comme représenté sur la figure 4 qui concerne un cycle de lecture avec le signal $\overline{CS}$ au niveau bas et le signal $\overline{W}$ au niveau haut, le passage en basse impédance se fait juste au moment où les données valides sont présentes et la partie hachurée du diagramme (a) est éliminée.

D'autre part, dans le cas des mémoires RAM standards telles que les SRAM et les DRAM, la remise à zéro initiale de la basule D est réalisée automatiquement. En effet, une RAM après mise sous tension est d'abord écrite avant d'être lue, ce qui entraine la mise haute impédance des sorties. Pour les autres types de mémoires, on peut prévoir un signal de remise à zéro à la mise sous tension.

**Revendications**

1. Dispositif d'autosynchronisation monté dans un circuit de sortie des mémoires travaillant en mode horloge interne, ces circuits de sortie comportant une porte "3 états" (P) placée en série entre un amplificateur de lecture (A) et une porte de sortie (S), caractérisé en ce qu'il est constitué par un circuit en logique séquentielle (10 à 20) ne permettant le passage de la porte "3 états" (P) en basse impédance qu'au moment où une information est disponible en sortie de l'amplificateur de lecture (A), l'amplificateur de lecture (A) étant commandé par le même signal horloge pulsé (Ø1) que le circuit en logique séquentielle, le signal horloge pulsé (Ø1) étant constitué par des impulsions dont la durée est au moins égale au temps de réponse de l'amplificateur de lecture (A), le circuit en logique séquentielle (10 à 20) ayant un temps de réponse égal au temps de réponse de l'amplificateur de lecture (A).

2. Dispositif selon la revendication 1, caractérisé en ce que le circuit en logique séquentielle est constitué par une bascule D (10) à verrouillage commandée par le signal horloge pulsé (Ø1) dont les sorties commandent la porte "3 états" et par une boucle de mémorisation (16 à 20).

3. Dispositif selon la revendication 2, caractérisé en ce que la borne D de la bascule D (10) est positionnée au niveau logique 1, au moins pendant le mode de lecture.

4. Dispositif selon l'une quelconque des revendications 2 à 3, caractérisé en ce que la remise à zéro de la bascule D (10) est réalisée par un circuit en logique combinatoire (11, 12) commandé par les signaux d'autorisation de lecture/écriture E et d'autorisation d'écriture W.

5. Dispositif selon la revendication 4, caractérisé en ce que le circuit en logique combinatoire est constitué par une porte NAND dont une des entrées reçoit le signal W et l'autre entrée la sortie d'un inverseur (12) dont l'entrée reçoit le signal E.

**6.** Dispositif selon l'une quelconque des revendications 2 à 5, caractérisé en ce que, lorsque la mémoire comporte le signal de commande d'initialisation de l'opération de lecture OE, les signaux Q et $\overline{Q}$ de la bascule D (10) sont envoyés respectivement sur une porte ET (15) et sur une porte OU (14) avant d'être envoyés sur la porte " 3 états " (P), la porte ET recevant sur son autre entrée le signal OE inversé et la porte OU recevant sur son autre entrée le signal OE.

**7.** Dispositif selon l'une quelconque des revendications 2 à 6, caractérisé en ce que la boucle de mémorisation est constituée de deux portes de transfert (16 et 17) commandées par le signal horloge $\emptyset1$.

**Claims**

**1.** An autosynchronization device arranged in an output circuit of memories operating in an internal clock mode, said output circuits comprising a "three state" gate (P) placed in series between a read amplifier (A) and an output gate (S), characterized in that it is constituted by a sequential logic circuit (10 through 20) only permitting the passage through the "three state" gate (P) at a low impedance when an item of information is available at the output of the read amplifier (A), the read amplifier (A) being controlled by the same pulsed clock signal ($\emptyset1$) as the sequential logic circuit, the pulsed clock signal ($\emptyset1$) being constituted by pulses whose duration is at least equal to the response time of the read amplifier (A), the sequential logic circuit (10 through 20) having a response time equal to the response time of the read amplifiers (A).

**2.** The device as claimed in claim 1, characterized in that the sequential logic circuit is constituted by a latched flipflop D (10) controlled by the pulsed clock signal ($\emptyset1$) whose outputs control the "three state" gate, and by a storage loop (16 through 20).

**3.** The device as claimed in claim 2, characterized in that the terminal D of the flipflop D (10) is set at the 1 logic level, at least in the read mode.

**4.** The device as claimed in either of the claims 2 and 3, characterized in that the resetting to zero of the flipflop D (10) is performed by a combinatory logic circuit (11 and 12) controlled by read/write enable signals E and by write enable signals W.

**5.** The device as claimed in claim 4, characterized in that the combinatory logic circuit is constituted by a NAND gate of which one input receives the signal W and of which the other input receives the output of an inverter (12) whose input receives the signal E.

**6.** The device as claimed in any one of the preceding claims 2 through 5, characterized in that if the memory comprises the control signal for the initialization of the read operation OE, the signals Q and $\overline{Q}$ of the flipflop D (10) are respectively fed to one AND gate (15) and to one OR gate (14) before being fed to the "three state" gate (P), the AND gate receiving at its other input the inverted OE signal and the OR gate receiving the OE signal at its other input.

**7.** The device as claimed in any one of the preceding claims 2 through 6, characterized in that the memory loop is constituted by two transfer gates (16 and 17) controlled by the clock signal $\emptyset1$.

**Patentansprüche**

**1.** Autosynchronisationseinrichtung, die in einer Ausgangsschaltung für in einer Betriebsart mit internem Takt arbeitende Speicher angebracht ist, wobei diese Ausgangsschaltungen ein Gatter mit "3 Zuständen" (P) aufweisen, das zwischen einem Leseverstärker (A) und einem Ausgangs-Gatter (S) in Reihe geschaltet ist, dadurch gekennzeichnet, daß sie eine sequentielle Logikschaltung (10 bis 20) umfaßt, die bei niedriger Impedanz das Gatter mit "3 Zuständen" (P) nur in dem Moment auf Durchlaß schaltet, in dem am Ausgang des Leseverstärkers (A) eine Information verfügbar ist, wobei der Leseverstärker (A) vom selben gepulsten Taktsignal ($\emptyset1$) wie die sequentielle Logikschaltung gesteuert wird, wobei das gepulste Taktsignal ($\emptyset1$) aus Impulsen gebildet wird, deren Dauer wenigstens gleich der Ansprechzeit des Leseverstärkers (A) ist und wobei die sequentielle Logikschaltung (10 - 20) eine Ansprechzeit besitzt, die gleich der Ansprechzeit des Leseverstärkers (A) ist.

6

**2.** Einrichtung gemäß Anspruch 1, dadurch gekennzeichnet, daß die sequentielle Logikschaltung eine vom gepulsten Taktsignal (Ø1) gesteuerte Verriegelungs-Kippschaltung D (10), deren Ausgaben das Gatter mit "3 Zuständen" steuern, und eine Speicherschleife (16 bis 20) umfaßt.

**3.** Einrichtung gemäß Anspruch 2, dadurch gekennzeichnet, daß sich der Anschluß D der Kippschaltung D (10) wenigstens während der Lesebetriebsart auf logischem Pegel 1 befindet.

**4.** Einrichtung gemäß einem der Ansprüche 2 bis 3, dadurch gekennzeichnet, daß das Rücksetzen auf Null der Kippschaltung D (10) von einer kombinatorischen Logikschaltung (11, 12) verwirklicht wird, die vom Lese-/Schreib-Freigabesignal E und vom Schreib-Freigabesignal W gesteuert wird.

**5.** Einrichtung gemäß Anspruch 4, dadurch gekennzeichnet, daß die kombinatorische Logikschaltung ein NICHT-UND-Gatter umfaßt, von dem einer seiner Eingänge das Signal W und der andere Eingang die Ausgabe eines an seinem Eingang das Signal E empfangenden Invertierers (12) empfängt.

**6.** Einrichtung gemäß einem der Ansprüche 2 bis 5, dadurch gekennzeichnet, daß die Signale Q und $\overline{Q}$ der Kippschaltung D (10) an ein UND-Gatter (15) bzw. an ein ODER-Gatter (14) geschickt werden, bevor sie an das Gatter mit "3 Zuständen" (P) geschickt werden, wenn der Speicher das Steuersignal OE für die Initialisierung der Leseoperation enthält, wobei das UND-Gatter an seinem anderen Eingang das invertierte Signal OE und das ODER-Gatter an seinem anderen Eingang das Signal OE empfängt.

**7.** Einrichtung gemäß einem der Ansprüche 2 bis 6, dadurch gekennzeichnet, daß die Speicherschleife zwei vom Taktsignal Ø1 gesteuerte Übertragungsgatter (16 und 17) umfaßt.

FIG_1

FIG_2

EP 0 271 406 B1

FIG_3

EP 0 271 406 B1

FIG_4